# EUROPEAN PATENT APPLICATION

(11) **EP 4 752 930 A1**
(43) Date of publication of application: **03.06.2026**
(21) Application number: 24216626.2
(22) Date of filing: 29.11.2024
(51) Int. Cl.: H01J 37/22, H01J 37/28, H01J 37/317

(54) **AN OPTICAL COMPONENT FOR A CHARGED-PARTICLE OPTICAL DEVICE**

(71) Applicant: ASML Netherlands B.V., 5500 AH Veldhoven (NL)
(72) Inventor: AKBULUT, Duygu, 5500 AH Veldhoven (NL); SAHIN, Ezgi, 5500 AH Veldhoven (NL); LÖW, Peter, 5500 AH Veldhoven (NL); BASTIAANS, Koen, Mathijs, 5500 AH Veldhoven (NL)
(74) Representative: ASML Netherlands B.V.

(57) **Abstract**

The present invention provides an optical component for a charged particle-optical device. The device is configured to project one or more charged particle beams towards a sample. The optical component is configured to receive optical radiation from an external waveguide and to direct the optical radiation towards a sample. The optical component comprises a photonic element and a coupling element. The photonic element is configured to project optical radiation towards the sample. The coupling element is configured to optically couple an external waveguide to the photonic element, the coupling element comprising two facets that are mutually angled and an optical path between the two facets.

## Description

### FIELD

The present invention relates to an optical component for use in a charged particle-optical device, the charged-particle optical device being configured to project one or more charged particle beams towards a sample.

### BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the sample (such as in a scanning electron microscopes (SEM)). Collecting interaction products that result from the interaction of the primary beam with the part of the sample, allows the electron microscope to collect data representing the probed part of the sample. The data may be processed/rendered for example by the electron microscope to generate an image representation of the part of the sample. The collected data for example as a generated image representation allows for measuring structures on the part of the sample, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

Photonic elements may be used manipulate optical radiation. In particular, a photonic element may be employed to manipulate the optical radiation and direct optical radiation to other components and/or modules in a system where the manipulated light is further to be utilized. In the context of assessment systems, for example inspection or metrology systems, a photonic element may be used, for example, to direct optical radiation towards the sample. In order to use the photonic element to manipulate optical radiation, optical radiation may be generated using an external optical radiation source and the optical radiation is then coupled into and out of the photonic element. Known means of coupling optical radiation into and/or out of a photonic element include grating couplers, edge couplers, cleaved waveguides, evanescent light couplers, and a combination of these structures with micro-optics components. Often, the coupling means that is selected is specific to the intended use case and is not readily adaptable to different use cases. There is therefore a problem of providing suitable coupling means for use in the compact available space in inspection or metrology systems.

### SUMMARY

The present invention concerns an optical component for use in a charged particle-optical device, the device being configured to project one or more charged particle beams towards a sample. The optical component being configured to receive optical radiation from an external waveguide and to direct the optical radiation towards a sample.

According to an aspect of the present invention, there is provided an optical component for a charged particle-optical device, the device being configured to project one or more charged particle beams towards a sample. The optical component comprises a photonic element and a coupling element. The photonic element is configured to project optical radiation towards the sample. The coupling element is configured to optically couple an external waveguide to the photonic element, the coupling element comprising two facets that are mutually angled and an optical path between the two facets.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1;
- Figure 5 schematically depicts an alternative multi-beam charged particle-optical device, for example of the assessment apparatus of Figure 1;
- Figure 6 schematically depicts part of the multi-beam charged particle-optical device of Figure 5;
- Figure 7 schematically depicts a detector array in plan view;
- Figure 8 schematically depicts a detector element in cross-section;
- Figure 9A-C are schematic diagrams showing different views of an optical component according to a first arrangement;
- Figure 10A-C are schematic diagrams showing different views of an optical component according to another arrangement;
- Figure 11 is a schematic diagram showing an optical component according to another arrangement;
- Figure 12 is a schematic diagram showing an optical component according to another arrangement;
- Figure 13A-B are schematic diagrams showing different views of an optical component according to another arrangement;
- Figure 14 is a schematic diagram showing a cross-sectional view of an optical component incorporated in a charged particle-optical device;
- Figure 15 is a schematic diagram showing a cross-sectional view of an optical component incorporated in a charged particle-optical device, according to another arrangement.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a sample and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a sample), each individual step must have a yield greater than 99.4%. If an individual step has a yield of 95%, the overall yield of the manufacturing process would be as low as 7.7%. It is desirable to determine defects quickly so as to maintain a high sample throughput, defined as the number of samples processed per hour.

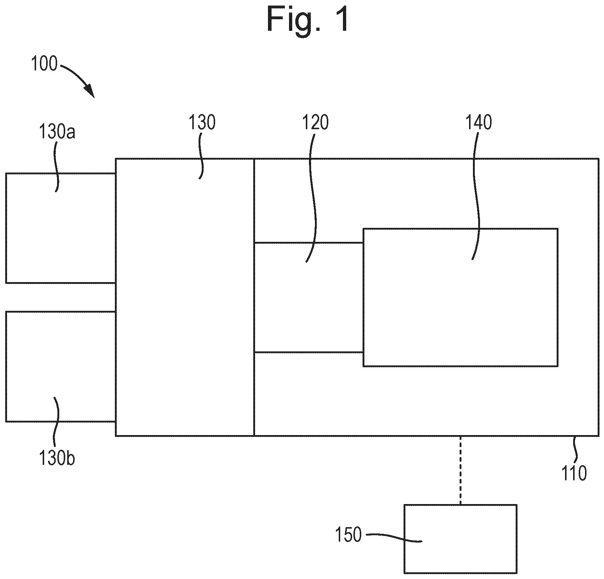

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

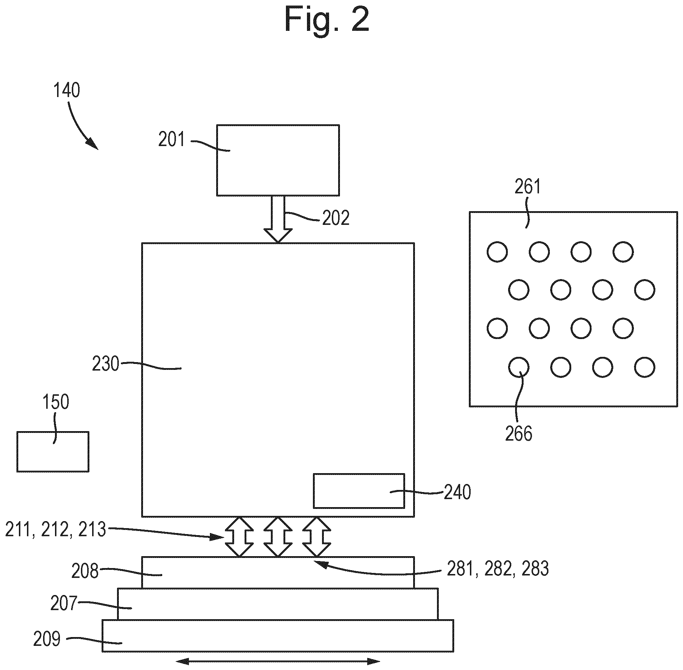

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

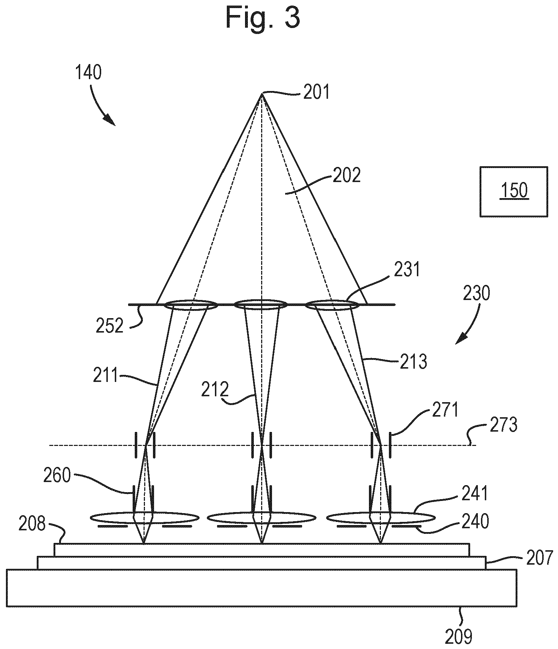

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

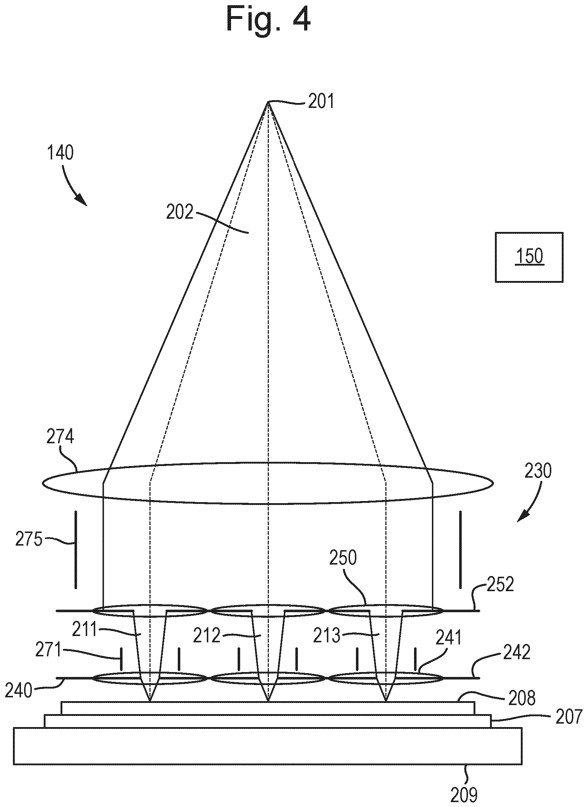

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

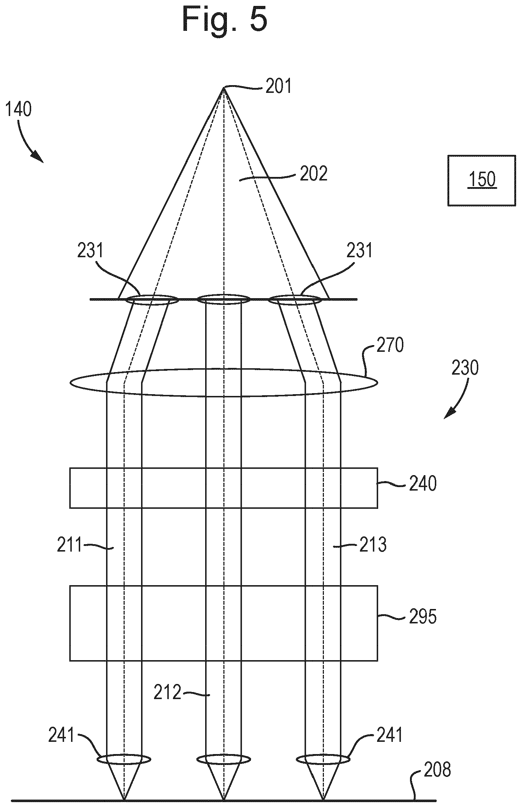

Figure 5 schematically depicts an electron-optical apparatus 140 of an assessment apparatus, e.g. the assessment apparatus 100 of Figure 1. The electron-optical apparatus 140 may be the electron-optical apparatus 140 of Figure 2 in which the electron-optical device 230 comprises a condenser lens array 231, a macro collimator 270, the detector array 240, a deflector array 295 and an objective lens array 241.

Features that are the same as those described above are given the same reference numerals. For conciseness, such features are not described in detail with reference to Figure 5. For example, the source 201, the condenser lens array 231, the objective lens array 241 and the sample 208 may be as described above.

The source is configured to generate a source beam 202. The condenser lens array 231 is configured to define a plurality of primary beams 211, 212, 213 from the source beam 202. The disclosure in EP1602121A1 of a lens array to split a beam into a plurality of beams, with the lens array providing a lens for each beam, is hereby incorporated by reference as a possible implementation of the condenser lens array 231.

In an embodiment the condenser lens array 231 comprises three plates 261 configured as an Einzel lens. An Einzel lens is configured to substantially ensure that the energy of an electron leaving the lens is the same as when the electron arrived at the lens. Such a lens maintains the energy of an electron between arriving and leaving the lens, for example the condenser lenses of the condenser lens array 231. Thus, dispersion only occurs within the condenser lens array 231 itself, thereby limiting chromatic aberrations. When a distance between the three plates of the Einzel lens is small, the chromatic aberrations caused by this condenser lens array 231 is limited, e.g. having a negligible effect.

In an embodiment the electron-optical device 230 comprises a collimator which may be macro collimator 270. The macro collimator 270 bends respective beams by an amount effective to ensure that a beam axis of each of the primary beams 211, 212, 213 derived from the primary 202 beam is incident on the sample 208 substantially normally (i.e. at substantially 90° to the nominal surface of the sample 208). In the current embodiment, the macro collimator 270 acts on all of the primary beams 211, 212, 213. The macro collimator 270 may comprise an electrostatic lens and/or a magnetic lens arrangement comprising a plurality of lens elements (e.g. a plurality of electrostatic and/or magnetic elements, e.g. forming a multipole).

In an embodiment the detector array 240 is configured to detect signal electrons by reference to the energy of the signal electron. For example, scintillators e.g. YAG do not directly detect electrons but generate light which is then detected. The signal electrons emitted from the sample 208 gain energy from the electromagnetic fields between the detector array 240 and the sample 208. In an embodiment, the objective lens array 241 is located between the detector array 240 and the sample 208.

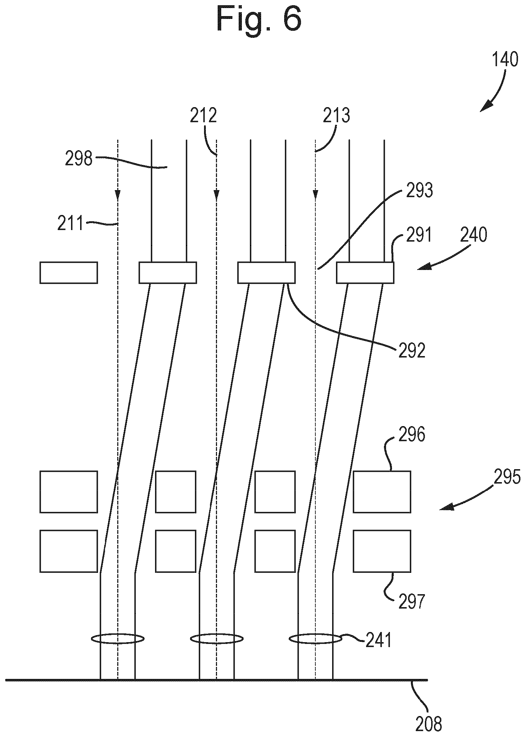

The electron-optical device 230 may comprise a deflector array 295 located between the detector array 240 and the objective lens array 241. The deflector array 295 may be referred to as a beam separator. The deflector array 295 may deflect signal electrons resulting from individual primary beams 211, 212, 213 along a path towards detector elements of a detector array 240 that is away from the paths of the primary beams towards the sample 208. The deflector array 295 may comprise a magnetic deflector array that is configured to provide magnetic fields to disentangle the primary electrons projected toward the sample 208 from the signal (e.g. secondary) electrons emitted from the sample 208. The deflector array 295 may comprise a Wien filter array. The deflector array 295 may comprise an electrostatic deflector array that is arranged to cooperate with the magnetic deflector array to achieve the disentangling of the paths of the primary electrons and signal electrons. Figure 6 is a close-up view of part of the electron-optical device 230 shown in Figure 5. In an embodiment the detector array 240 comprises an electron to photon converter array 291, e.g. a scintillator array. The electron to photon converter array 291 comprises a plurality of fluorescent elements (e.g. comprising YAG) which may be in the form of fluorescent strips 292 extending across the beam grid. Each fluorescent strip 292 is located in the plane of the electron to photon converter array 291. At least one fluorescent strip 292 is arranged between two adjacent primary beams 211, 212, 213 projected towards the sample 208. In an embodiment, the fluorescent strips 292 extend substantially across the beam grid. Alternatively, the electron to photon converter array 291 may comprise a plate of a fluorescent material with openings 293 for the primary beams 211, 212, 213 or an array of elements of similar size around the beams and that may be spaced apart. The primary beams 211, 212, 213 are projected through the plane of the electron to photon converter array 291, e.g. via the openings 293 such as between the fluorescent strips 292, towards the deflector array 295.

In an embodiment the deflector array 295 comprises a magnetic deflector 296 and an electrostatic deflector 297. The electrostatic deflector 297 is configured to counteract the deflection of the magnetic deflector 296 for the primary beams 211, 212, 213 transmitted towards the sample 208. Accordingly, the primary beams 211, 212, 213 may be shifted to a small extent in the horizontal plane. The beam paths downbeam of the deflector array 295 are substantially parallel to the beam paths upbeam of the deflector array 295.

In an embodiment the objective lens array 241 comprises a plurality of plates for guiding signal electrons emitted from the sample 208 towards the deflector array 295. For the signal electrons, which travel in opposite direction with respect to the projected primary beams 211, 212, 213, the electrostatic deflector 297 does not counteract the deflection of the magnetic deflector 296. Instead, the deflections of the secondary electrons by the electrostatic deflector 297 and the magnetic deflector 296 add up. Accordingly, the signal electrons are deflected to travel at an angle with respect to the optical axis in order to transmit the secondary electrons onto the fluorescent strips 292 of the detector array 240.

At the fluorescent strips 292, photons are created upon incidence of the signal electrons. In an embodiment, the photons are transported from the fluorescent strip 292 to a photo detector (not shown) via a photon transport unit. In an embodiment, the photon transport unit comprises an array of optical fibers 298. Each optical fiber 298 comprises an end which is arranged adjacent or attached to one of the fluorescent strips 292 for coupling photons from the fluorescent strip 292 into the optical fiber 298, and another end which is arranged to project photons from the optical fiber 298 onto the photo detector. In a different arrangement, the optical to electrical converter (or photo diode) is located immediately adjacent the electron to light converter, avoiding the need for optical fibers.

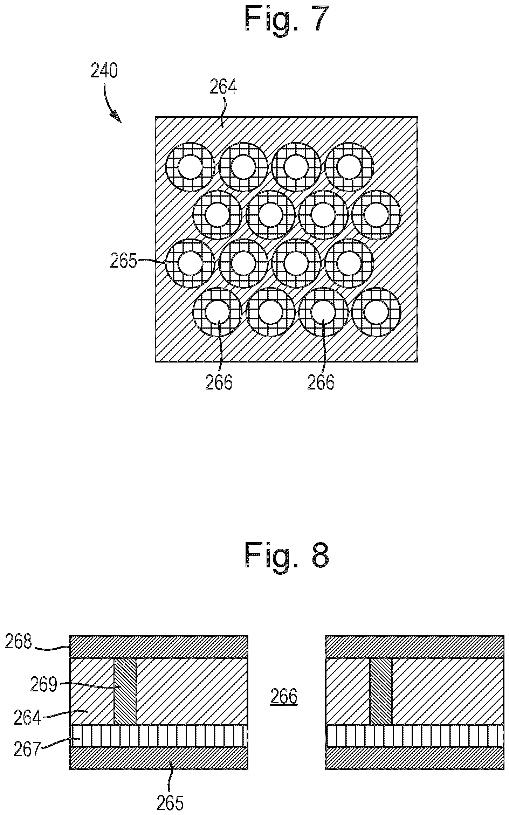

Figure 7 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 7, the beam apertures 266 are in a hexagonal close packed array. The beam apertures 266 can also be differently arranged, e.g. in a rectangular array.

Figure 8 depicts at a larger scale a part of the detector array 240 in cross section. The detector elements 265 form the bottom surface, i.e. the surface the closest to the sample 208, of the detector array 240. Between the detector elements 265 and the main body of the detector substrate 264 a logic layer 267 may be provided. At least part of the signal processing system, for example for amplification, may be incorporated into the logic layer 267.

A wiring layer 268 is provided on the backside of, or within, the detector substrate 264 and connected to the logic layer 267 by through-substrate vias 269. The number of through-substrate vias 269 need not be the same as the number of beam apertures 266. In particular if the electrode signals are digitized in the logic layer 267 only a small number of through-silicon vias may be required to provide a data bus. The wiring layer 268 may include control lines, data lines and power lines. It will be noted that in spite of the beam apertures 266 there is ample space for all necessary connections. The detector array 240 may be fabricated using CMOS technology, but may also be fabricated using bipolar or other manufacturing techniques. A printed circuit board and/or other semiconductor chips may be provided on the detector array 240.

Photonic elements may be used manipulate optical radiation. In particular, a photonic element may be employed to manipulate the optical radiation and direct optical radiation to other components and/or modules in a system where the manipulated light is further to be utilized. In the context of the charged particle-optical device 230, for example as described above in reference to any of Figures 1 to 8, a photonic element may be used to direct optical radiation towards the sample 208. For example, where the charged particle-optical device 230 is an electron-optical device, one or more electron beams scan the sample 208. A photonic element integrated into the charged particle-optical device may be configured to receive optical radiation from an external optical radiation source and to illuminate the sample 208 with the optical radiation in order to improve defect contrast during defect inspection. This technique, which may be referred to as voltage contrast, may be used to measure whether there is a proper electrical connection between a contact and the substrate of the sample 208. The photonic element may be configured to manipulate optical radiation on a planar circuit. The planar circuit may be an integrated optical circuit, such as a photonic integrated circuit. In order to use the photonic element to manipulate optical radiation, optical radiation may be generated using an external optical radiation source and the optical radiation is then coupled into and out of the photonic element. Widely utilized means of coupling optical radiation into and/or out of a photonic element include grating couplers, edge couplers, cleaved waveguides, evanescent light couplers, and a combination of these structures with micro-optics components. Often, the coupling means that is selected is specific to the intended use case and is not readily adaptable to different use cases. Integration of a photonic element into the charged particle-optical device 230, as described above, can pose a challenge to the coupling of optical radiation from the external radiation source to the photonic element. Given the different components in the charged particle-optical device 230, for example as shown in Figs. 1-8, the photonic element may need to be integrated within a very compact space - for example, within a spacing in the order of 10um-200um with respect to adjacent components of the charged particle-optical device 230. As a result, there is a need to provide suitable coupling means for coupling external optical radiation to the photonic element integrated in a compact space in the charged particle-optical device 230.

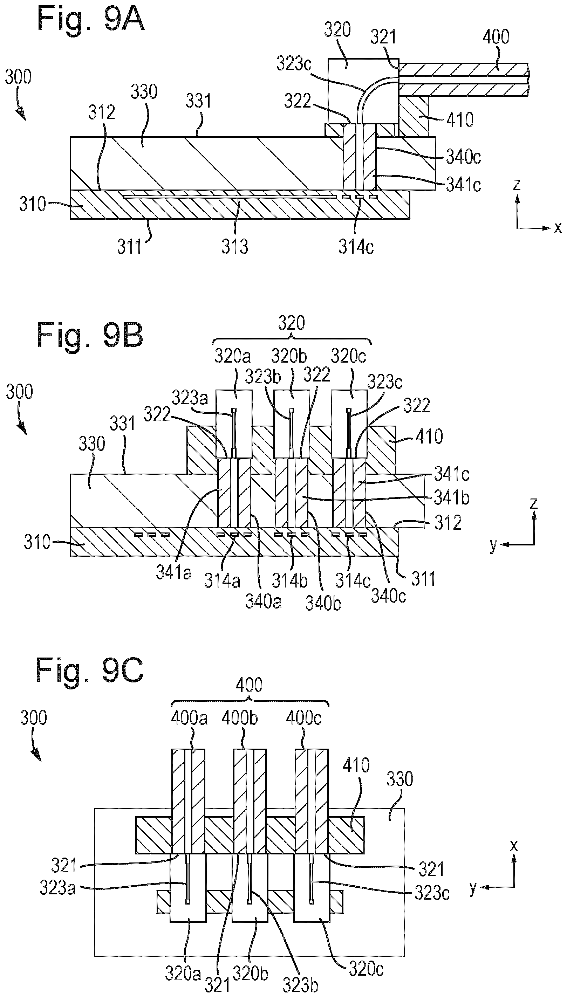

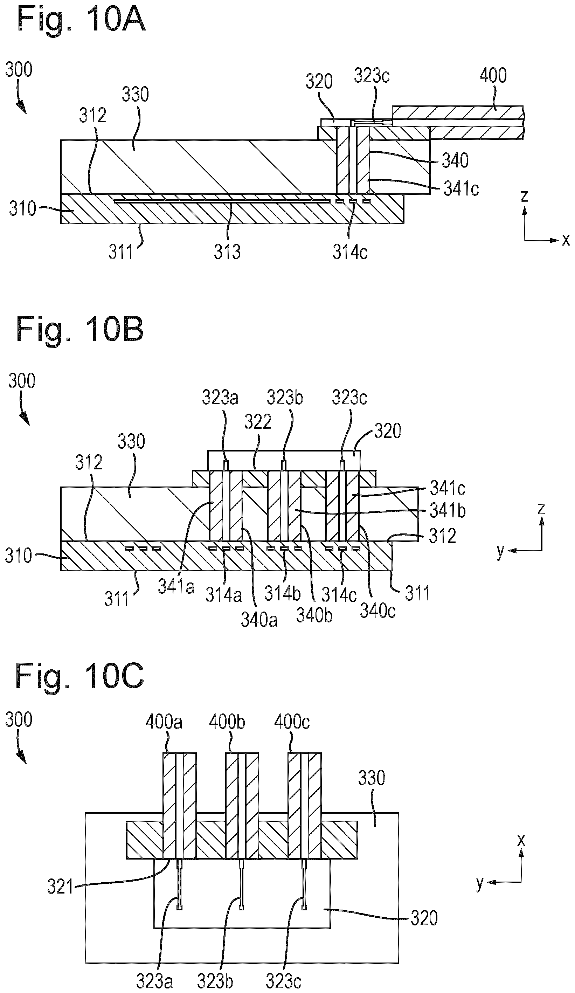

In a particular example, in the charged particle-optical device 230, the thickness of the photonic element 310 (see, for example, see 310 in Figs. 9, 10) may be 50 microns or less, preferably 25 microns or less, more preferably 20 microns or less, yet more preferably 15 microns or less. The photonic element 310 optionally comprises an integrated optical circuit 313. The integrated optical circuit 313 of the photonic element 310 may be formed within a membrane preferably having a thickness of less than 1 micron. For example, the membrane comprising the integrated optical circuit 313 may have a thickness in the order of hundreds of nanometres. As discussed above, the coupling of the external waveguide to the photonic element is to be implemented in a very compact space. A possible configuration is that the optical radiation is provided, from an external optical radiation source, via an external waveguide, with the external waveguide being arranged parallel to the photonic element. The photonic element may comprise a major surface, and a further major surface. The further major surface may be parallel to the major surface and may face an opposite direction than the major surface. The optical radiation may enter the photonic element via the further major surface, which may be an upper surface, of the photonic element. The optical path of the optical radiation therefore makes a bent or curved path, such as an approximately 90° bend, between leaving the external waveguide and entering the photonic element at the further major surface. The external waveguide may be an optical fibre. The fibre bend radii of typical optical fibres are typically at the orders of a number of millimetres or even centimetres. With the limited space available for integration of a photonic element in the charged particle optical device, it is therefore undesirable and impractical to achieve the above-mentioned bend in the optical path by bending the optical fibre to attach the optical fibre to the photonic element. It is therefore desirable to provide a coupling means to achieve a bend of the optical path between the external waveguide and the photonic element in a compact space.

Figures 9A-C, 10A-C, 11, 12 and 13A-B show arrangements of an optical component 300 for a charged particle-optical device 230, where the device is configured to project one or more charged particle beams towards a sample 208 and the optical component 300 is configured to project optical radiation towards the sample 208. The optical component 300 comprises a photonic element 310 and a coupling element 320. The photonic element 310 is configured to project optical radiation, e.g., light, towards the sample 208. The photonic element 310 may, for example, comprise an optical emitter configured to direct light from within the photonic element 310 towards the sample 208. The optical emitter may comprise or consist of a coupling arrangement, such as a grating coupler. The optical emitter may be comprised within an integrated optical circuit 313 of the photonic element 310. The optical emitter is desirably configured to receive optical radiation traveling in one direction (e.g., through the integrated optical circuit 313 of the photonic element 310) and to re-direct the optical radiation to travel in a second direction (e.g., towards the sample 208). The optical radiation may be light. The light may have a wavelength in the visible wavelength range, for example, one or more wavelengths between 350nm-1000nm, preferably between 400nm-950nm and more preferably between 450nm-850nm. The coupling element 320 is configured to optically couple an external waveguide 400 to the photonic element 310. The coupling element 320 may be configured to couple optical radiation into the photonic element 310 at a first location on the photonic element 310. The photonic element 310 may be configured to direct the optical radiation along the photonic element 310. The photonic element 310 may be configured to emit the optical radiation out of the photonic element 310 towards the sample 208 (e.g., via the optical emitter), at a second location on the photonic element 310. The first location (at which optical radiation enters the photonic element 310) may be farther from the path of the charged particle optical beams than the second location (at which optical radiation exits the photonic element 310) is from the path of the charged particle optical beams.

During use, the external waveguide 400 may enable light from an external optical source, e.g. a laser, to be directed to the coupling element 320. In this way, the optical component 300 may be used to direct optical radiation from an external optical source to the sample 208.

The coupling element 320 comprises two facets 321, 322. The two facets 321, 322 are mutually angled. The coupling element 320 provides an optical path 323a-c between the two facets 321, 322. One facet 321 of the two facets 321, 322 is optically coupled to the external waveguide 400. The other facet 322 of the two facets is configured to direct optical radiation on an optical path towards the photonic element 310. The coupling element 320, including the two facets 321, 322, may therefore enable optical radiation to enter the coupling element via one facet 321, the optical radiation travelling in a first direction, and to leave the coupling element via the other facet 322, the optical radiation travelling in a second direction different to the first direction. For example, the optical radiation may be travelling on a path perpendicular to the one facet 321 to enter the coupling element 320, and the optical radiation may be re-directed to travel on a path perpendicular to the other facet 322 to exit the coupling element 320. In this way, the coupling element 320 may beneficially provide a bent optical path 323a-c for optical radiation entering in the first direction from the optical waveguide 400 to be directed to the second direction, different to the first direction, towards the photonic element 310.

The optical component 300, including the coupling element 320 having the two facets 321 322, may enable optical radiation to be redirected towards the sample 208. As already discussed earlier in the description, there may be limited space available in a charged particle-optical device 230 for the integration of the photonic element. Due to this, it may not be practically feasible for the external waveguide 400 to be coupled directly to the photonic element 310. In this scenario, the coupling element 320 may be used to provide a bent optical path, which changes a direction in which the optical radiation travels from the external waveguide 400 towards the photonic element 310. The photonic element 310 may be configured to direct the optical radiation in a desired direction, for example, towards the sample 208.

Figures 9A-C shows an optical component 300 having a coupling arrangement 320 comprising a plurality of optical coupling elements 320a-c. As seen in Figure 9B, the plurality of optical elements 320a-c are arranged in an array corresponding to an array of external waveguides 400a-c (see Figure 9C). Figure 9A provides a cross-sectional view of the optical component 300 from the front, in the x-z plane. Figure 9B provides a cross-sectional view of the optical component 300 from the side, in the y-z plane. Figure 9C provides a top-down plan view in the x-y plane, from above the optical component 300. Each optical element 320a-c is configured to provide an optical path between a corresponding external waveguide 400a-c and the photonic element 310. In one embodiment, each optical element 320a-c comprises an integrated optical circuit configured to provide an optical path between a corresponding external waveguide 400a-c and the photonic element 310. As shown in Figure 9A, the integrated optical circuit in each optical element 320a-c provides a curved or bent optical path for the optical radiation propagating from the external waveguide 400 to the photonic element 310. In one embodiment, the proposed coupling arrangement of Fig. 9A provides a bend of approximately 90° in the optical path between an external waveguide (400a-c) and the photonic element 310. In this arrangement, the optical radiation is preferably coupled out of the coupling element 320 towards the photonic element 310 via an edge coupler. In Figures 9A-C, each of the optical coupling elements 320a-c is a planar optical element arranged in a plane perpendicular to a plane in which the photonic element 310 is arranged, e.g., each optical coupling element 320a-c is arranged in a vertical plane. The particular details of the arrangement of Figures 9A-C are described in more detail later in the description. Although in Figures 9A-C each of the optical coupling elements 320a-c is a planar optical element arranged in a plane perpendicular to a plane in which the photonic element 310 is arranged, other arrangements are possible. For example, in other embodiments (not shown), one or more of the optical coupling elements 320a-c may be planar optical elements arranged at a non-perpendicular angle with respect to a plane in which the photonic element 310 is arranged.

Figures 10A-C shows an optical component 300 having a coupling element 320. Figure 10A provides a cross-sectional view of the optical component 300 from the front, in the x-z plane. Figure 10B provides a cross-sectional view of the optical component 300 from the side, in the y-z plane. Figure 10C provides a top-down plan view in the x-y plane, from above the optical component 300. The coupling element 320 comprises an integrated optical circuit configured to provide a plurality of optical paths 323a-c between a corresponding plurality external waveguides 400a-c and the photonic element 310. As shown in Figure 10A, the integrated optical circuit of the coupling element 320 provides a predominantly straight optical path within the coupling element 320. In one embodiment, the proposed coupling element 320 of Figures 10A-C comprises a coupling arrangement, disposed at or adjacent the facet 322. The coupling arrangement is configured to direct optical radiation from the optical paths 323a-c towards the photonic element 310. The coupling arrangement disposed at or adjacent the facet 322 is configured such that optical radiation is turned towards the photonic element 310. In one embodiment, the proposed coupling element 320 of Figures 10A-C is configured to turn the optical radiation by approximately 90° in the optical path between the external waveguide (400a-c) and the photonic element 310. In this arrangement, the optical radiation is preferably coupled out of the coupling element 320 towards the photonic element 310 via a grating coupler. In Figures 10A-C, the coupling element 320 is a planar optical element arranged in a plane parallel to a plane in which the photonic element 310 is arranged, e.g., the coupling element 320 is arranged in a horizontal plane. The particular details of the arrangement of Figures 10A-C are described in more detail below.

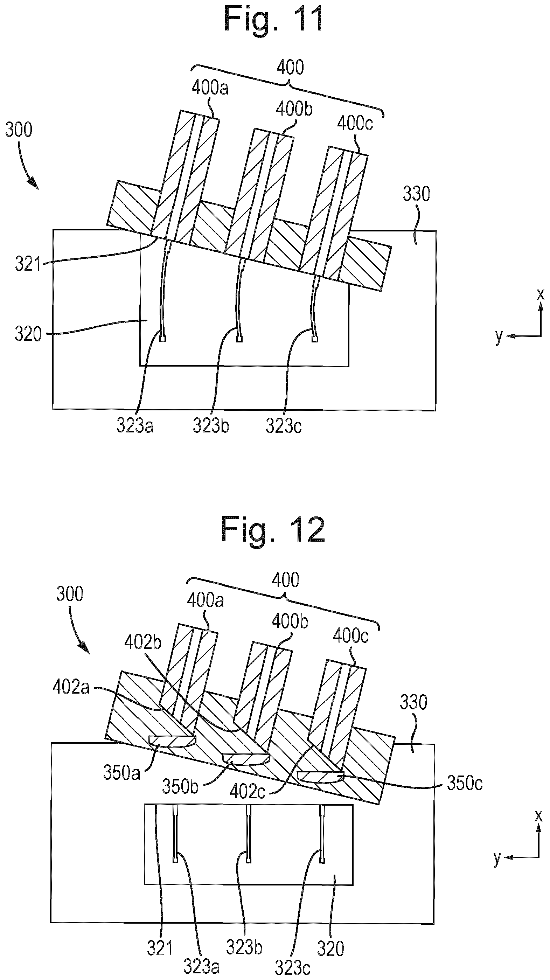

Figures 11 and 12 show variations of the optical component 300 of Figures 10A-C. In the variations of Figures 11 and 12, the external waveguide array 400 is arranged at a non-perpendicular angle (as viewed from above in the x-y plane) with respect to the coupling element 320 and/or the photonic element 310. Figures 11 and 12 each provide a plan view, in the x-y plane, from above the optical component 300.

In some arrangements, the external waveguide 400 has an optical axis (alternatively referred to as the centerline of the waveguide 400 or the propagation direction of optical radiation through the waveguide 400) which, at a coupling point between the external waveguide 400 and the coupling element 320, extends in a first direction. The optical radiation may therefore travel in the first direction when entering the coupling element 320 from the external waveguide 400. The coupling element 320 is configured to re-direct the optical radiation to a second direction (e.g., towards the photonic element 310), different to the first direction. In some arrangements, the second direction is perpendicular to the first direction. In other words, the coupling element 320 may be configured to redirect the optical radiation on an optical path substantially perpendicular to the optical axis of the external waveguide 400. For example, the external waveguide 400 may be arranged such that the optical axis of the optical waveguide 400 extends horizontally and it may be desirable to re-direct the optical radiation to a substantially vertical optical path. In an arrangement such as this, the two facets 321, 322 may be arranged substantially perpendicular to each other. In the arrangement of Figures 9A-C and 10A-C one facet 321 is arranged to extend in a vertical plane (X-Z plane), and the other facet 322 extends in a horizontal plane (X-Y plane). In other examples, the angle between the two facets 321, 322 may be less than or greater than 90°, for example, the angle may be between 45° and 135°.

The two facets 321, 322 are configured to optically couple the external waveguide 400 to the photonic element 310. In other words, optical radiation from the external waveguide 400 may enter the coupling element 320 via one facet 321 of the two facets 321, 322, and optical radiation may exit the coupling element 320, on an optical path towards the photonic element 310, via the other facet 322 of the two facets 321, 322.

The photonic element 310 may be a planar photonic element 310. The photonic element 310 may be larger in two in-plane directions (X-Y directions of Figures 9-15) and smaller in an out-of-plane direction (Z-direction of Figures 9-15). In other words, the width and breadth of the photonic element 310 may be larger than the thickness of the photonic element 310. For example, the photonic element 310 may have a substantially plate-like form. The photonic element 310 may comprise a major surface 311 on a first side, facing towards the sample 208. The photonic element 310 may comprise a further major surface 312 on a second side, opposite to the first side, facing away from the sample 208.

In a preferred arrangement, the photonic element 310 comprises an integrated optical circuit, for example a photonic integrated circuit. As shown in Figures 9A-B and 10A-B, the integrated optical circuit 313 of the photonic element 310 may be embedded within the photonic element 310. In another arrangement (not shown) the integrated optical circuit 313 of the photonic element 310 may be disposed on a major surface 311 of the photonic element 310. In particular, the integrated optical circuit 313 of the photonic element 310 may be arranged on or adjacent the major surface 311 of the photonic element 310 which faces the sample 208 during use. The integrated optical circuit 313 of the photonic element 310 is configured to enable to the photonic element 310 to project optical radiation towards the sample 208. The coupling element 320 may be configured to optically couple the external waveguide 400 to the integrated optical circuit 313 of the photonic element 310.

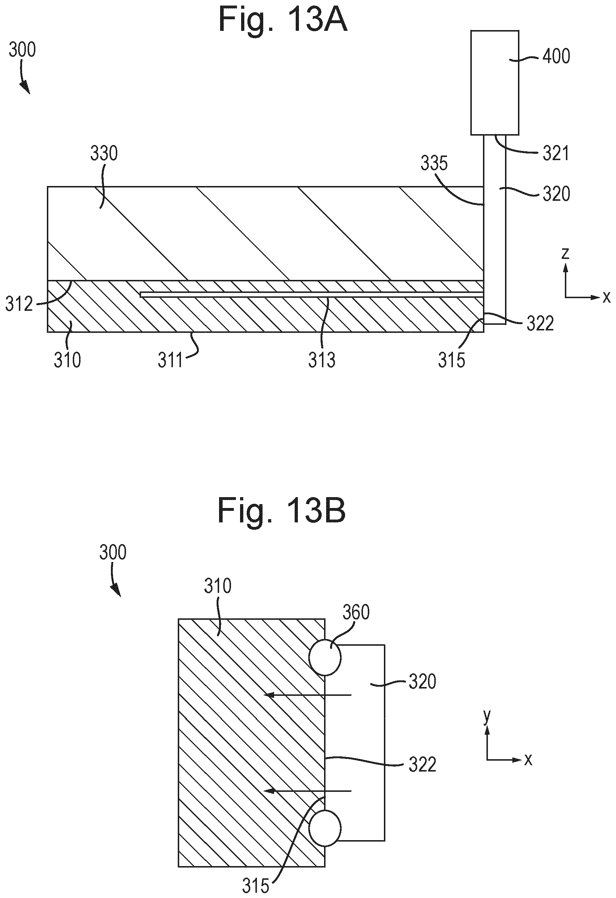

In some arrangements, the coupling element 320 may be disposed on the photonic element 310. For example, in one arrangement (not shown in the figures) the coupling element 320 may be disposed on a further major surface 312 of the photonic element 310, where the further major surface 312 may be parallel to the major surface 311 and may face away from the sample 208. In another example, for example as shown in Figures 13A-B, the coupling element 320 may be disposed on a side surface 315 of the photonic element 310. The side surface 315 may be adjacent and perpendicular to the major surface 311.

In other arrangements, the optical component 300 may further comprise a substrate 330 disposed between the photonic element 310 and the coupling element 320. In other words, the substrate 330 is disposed on the further major surface 312 of the photonic element 310. The substrate 330 may have at least one through-hole 340a-c extending between the coupling element 320 and the photonic element 310. In this arrangement, the optical path of optical radiation between the coupling element 320 and the photonic element 310 extends through the through-hole 340a-c. The at least one through-hole 340a-c preferably comprises a plurality of through-holes 340a-c. Each through-hole 340a-c is desirably configured to correspond to a corresponding optical path 323a-c of the coupling element 320.

The optical component 300 may comprise an additional optical element in the optical path between the coupling element 320 and the photonic element 310. The additional optical element is configured to direct optical radiation through the through-hole 340a-c towards the photonic element 310. In the arrangements shown in Figures 9A-C and 10A-C, this additional optical element is an optical transmission element 341a-c extending through the through-hole 340a-c of the substrate 330 and having an end optically coupled to the photonic element 310, wherein one facet 322 of the coupling element 320 is optically coupled to the other end of the optical transmission element 341a-c. The optical transmission element 341a-c may be any element suitable for transmitting optical radiation from the coupling element 320 to the photonic element 310. For example, the optical transmission element 341a-c may be an optical via or an optical fiber. In another arrangement, not shown in the figures, the additional optical element may comprise an optical lens configured to direct optical radiation from the coupling element 320 through the through-hole 340a-c to the photonic element 310. For example, the additional optical element may be disposed within the through-hole 340a-c, or between the coupling element 320 and the through-hole 340a-c.

In the arrangements shown in Figures 9A-C and 10A-C, the through-hole 340a-c is perpendicular to the major surface 311 of the photonic element 310. In alternative arrangements, not shown in the figures, the through-hole 340a-c may be at an angle less than or greater than 90° to the major surface 311 of the photonic element 310. The angle may be between 40° and 140°, preferably between 70° and 110°, more preferably between 80° and 100°, yet more preferably the angle may be between 85° and 95°. In the arrangements shown in Figures 9A-C and 10A-C, the through-hole 340a-c is shown as having a cross-section which has a constant shape and size along the entire length of the through-hole 340a-c. In an alternative arrangement (not shown in the Figures), the size and/or shape of the cross-section of the through-hole 340a-c may vary along the length of the through-hole 340a-c. For example, the through-hole 340a-c may have a larger cross-section at one end than the other.

In arrangements such as shown in Figures 9A-C and 10A-C, an optical transmission element 341a-c extends through the through-hole 340a-c. With an arrangement including this optical transmission element 341a-c, the angle between the through-hole 340a-c and the major surface 311 of the photonic element 310 is preferably set appropriately for the numerical aperture of the optical transmission element 341a-c.

The optical component 300 may further comprise a grating coupler arrangement 314a-c configured to couple optical radiation into of the photonic element 310. In the arrangements shown in Figures 9A-C and 10A-C, the photonic element 310 comprises the at least one grating coupler 314a-c. The grating coupler arrangement 314a-c may optionally be considered to be comprised in the integrated optical circuit 313 of the photonic element 310. As shown in Figures 9 and 10, the at least one grating coupler 314a-c desirably comprises a plurality of grating couplers 314a-c. Each grating coupler 314a-c desirably corresponds to a corresponding optical path 323a-c. The grating coupler 314a-c is configured to direct optical radiation, which has passed through the through-hole 340a-c, into the photonic element 310. In particular, in the arrangements of Figures 9A-C and 10A-C, the grating coupler 314a-c is configured to receive optical radiation from the optical transmission element 341a-c and to direct the received optical radiation into the integrated optical circuit 313 of the photonic element 310. The grating coupler 314a-c is configured to re-direct optical radiation - that is, the grating coupler 314a-c is preferably configured to receive optical radiation from one direction and to emit optical radiation in another direction, different to the one direction. The grating coupler 314a-c may receive optical radiation travelling in the one direction, re-direct the optical radiation and emit the optical radiation along an optical path in the other direction. The one direction may be the direction at which the optical radiation is incident on the grating coupler 314a-c, and the other direction is the direction in which the optical radiation is emitted from the grating coupler 314a-c. For example, the one direction may be normal to the plane of the grating coupler 314a-c, and the other direction may be in the plane of the grating coupler 314a-c. In other words, the grating coupler 214a-c is configured to turn the optical path of the optical radiation by an angle between the one direction and the other direction. The angle may be between 40° and 140°, preferably between 70° and 110°, more preferably between 80° and 100°, yet more preferably the angle may be between 85° and 95°, for example 90°. For example, as shown in Figures 9A-C and 10A-C, the optical radiation may travel on a substantially vertical path along the optical transmission element 341a-c (e.g., a negative Z direction in Figures 9A-C and 10A-C) and then be received and re-directed or diffracted by the grating coupler 314a-c to a substantially horizontal path through the photonic element 310 (e.g., a negative X direction in Figures 9A-C and 10A-C).

The optical component 300 may further comprise at least one edge coupler configured to direct optical radiation from the external waveguide 400 to the coupling element 320. For example, the edge coupler may be provided at or adjacent to facet 321 which is optically coupled to the external waveguide 400. The edge coupler is configured to receive optical radiation from the external waveguide 400 into the coupling element 320. In the arrangement of Figures 9A-C and 10A-C, the coupling element 320 comprises the at least one edge coupler.

The optical component 300 may further comprise a further edge coupler configured to couple optical radiation out of the coupling element 320 towards the photonic element 310. For example, the further edge coupler may be provided at or adjacent to facet 322 which is configured to direct optical radiation towards the photonic element 310. In the arrangement of Figures 9A-C, this facet 322 is adjacent the through-hole 340a-c and is configured to direct optical radiation through the through-hole 340a-c via the optical transmission element 341a-c. The further edge coupler is configured to couple and direct optical radiation from the coupling element 320 towards the optical transmission element 341a-c. In the arrangement of Figures 9A-C, the optical component 300 preferably comprises the further edge coupler in order to direct optical radiation from the coupling element 320 towards the photonic element 310. For example, the coupling element 320 may comprise the at least one further edge coupler. In an alternative arrangement, the optical transmission element 341a-c may comprise the at least one further edge coupler.

As described above, the external waveguide arrangement 400 may comprise a plurality of external waveguides 400a-c, which may be arranged in an array. For example, in the arrangement of Figures 9A-C, the external waveguide arrangement 400 comprises a plurality of external waveguides 400a-c. Each of the external waveguides 400a-c is configured to direct light from an external optical source to the coupling element 320. For example, the external waveguides 400a-c may be optical fibres. The coupling arrangement 320 comprises one or more coupling elements 320a-c. In the arrangement of Figures 9A-C, the coupling arrangement 320 comprises a plurality of coupling elements 320a-c. Each of the one or more coupling elements 320a-c is configured to provide an optical path 323a-c, between the two facets 321, 322, for optical radiation from a corresponding external waveguide 400a-c. In other words, there may be a plurality of external waveguides 400a-c each configured to direct optical radiation to a corresponding coupling element 320a-c of the coupling arrangement 320. Each coupling element 320a-c may receive optical radiation from the corresponding external waveguide 400a-c and direct the path of the optical radiation towards the photonic element 310. The coupling elements 320a-c may each comprise an integrated optical circuit, such as a photonic integrated circuit. The integrated optical circuits of the coupling elements 320a-c are each configured to direct the optical path from one facet 321 to the other facet 322. In the arrangement shown in Figures 9A-C, the integrated optical circuit of each coupling element 320a-c is configured to transmit optical radiation from the corresponding external waveguide 400a-c to the photonic element 310.

The optical transmission elements 341a-c and/or the external waveguides 400a-c may be secured in place by an adhesive. In particular, the optical transmission elements 341a-c and/or external waveguides 400a-c may each comprise an outer rim and the outer rim may be adhered to the surface to which the optical transmission element 341a-c or external waveguide 400a-c is coupled. In particular, each coupling element 320a-c of the coupling arrangement 320 may be adhered to a corresponding external waveguide 400a-c. Each corresponding external waveguide 400a-c may be supported in place via the aid of a V-groove. In an arrangement, such as that of Figures 9A-C, having an external waveguide 400 comprising a plurality of external waveguides 400a-c, the external waveguides 400a-c may be supported by a V-groove array assembly 410. The V-groove array assembly 410 may be adhered to the coupling element 320. The V-groove array assembly may optionally also be adhered to a surface 331 of the substrate 330. In the arrangement of Figures 9A-C, the photonic element 310 is disposed at a lower (downbeam) surface side of the substrate 330 and the V-groove array assembly is adhered to an upper (upbeam) surface 331 of the substrate 330.

The optical component 300 may further comprise at least one further grating coupler configured to couple optical radiation out of the coupling element 320 towards the photonic element 310. For example, each further grating coupler may be provided at or adjacent to facet 322 which is configured to direct optical radiation towards the photonic element 310. In the arrangement of Figures 10A-C, this facet 322 is adjacent the corresponding through-hole 340a-c and is configured to direct optical radiation through the through-hole 340a-c via the optical transmission element 341a-c. The further grating coupler is configured to emit optical radiation from the coupling element 320 towards the optical transmission element 341a-c. In the arrangement of Figures 10A-C, the optical component 300 preferably comprises the further grating coupler in order to direct optical radiation from the coupling element 320 towards the photonic element 310. For example, the coupling element 320 may comprise the at least one further grating coupler.

The further grating coupler is configured to re-direct optical radiation to travel in a different direction. The further grating coupler is preferably configured to receive optical radiation from one direction and to emit optical radiation in another direction at an angle to the one direction. In other words, the one direction is the direction at which the optical radiation is incident on the grating coupler, and the other direction is the direction in which the optical radiation is emitted from the grating coupler. For example, the one direction may be normal to the plane of the further grating coupler, and the other direction may be in the plane of the further grating coupler. The angle may be between 40° and 140°, preferably between 70° and 110°, more preferably between 80° and 100°, yet more preferably the angle may be between 85° and 95°, for example 90°. For example, as shown in Figures 10A-C, the optical radiation may travel on a substantially horizontal path through the coupling element 320 (e.g., a negative X direction in Figures 10A-C) and then be received and re-directed by the further grating coupler to a substantially vertical path into the optical transmission element 341a-c (e.g., a negative Z direction in Figures 10A-C).

As described above, the external waveguide arrangement 400 may comprise one or more external waveguides 400a-c. In the arrangement of Figures 10A-C, the external waveguide comprises a plurality of external waveguides 400a-c, which are preferably arranged in an array. Each of the external waveguides 400a-c is configured to direct optical radiation from an external optical source to the coupling element 320. For example, the external waveguides 400a-c may be optical fibres. The coupling element 320 of Figures 10A-C comprises an integrated optical circuit, such as a photonic integrated circuit. The integrated optical circuit of the coupling element 320 is configured to provide a plurality of optical paths 323a-c between the two facets 321, 322. Each optical path 323a-c is configured for optical radiation from a corresponding external waveguide 400a-c. In other words, there may be a plurality of external waveguides 400a-c each configured to direct optical radiation to a corresponding optical path 323a-c of the integrated optical circuit of the coupling element 320. Each optical path 323a-c may receive optical radiation from the corresponding external waveguide 400a-c and direct the optical radiation towards the photonic element 310. The integrated optical circuit of the coupling element 320 provides optical paths 323a-c directed from one facet 321 to the other facet 322 of the coupling element 320. In the arrangement shown in Figures 10A-C, the integrated optical circuit of the coupling element 320 is arranged to transmit optical radiation from the plurality of external waveguides 400a-c to the photonic element 310.

The arrangement of Figures 10A-C has the advantage that the coupling element 320 may be a substantially planar optical element. In other words, a height of the planar coupling element 320 may be lesser than the corresponding height of the coupling element 320a-c in Figures 9A-C. Furthermore, the coupling element 320 of Figures 10A-C may provide a plurality of optical paths 323a-c, to direct optical radiation from a plurality of external waveguides 400a-c. The number of coupling elements 320 in the coupling arrangement may be reduced compared to the arrangement of Figures 9A-C, which comprises an array of coupling elements 320a-c and each coupling element 320a-c defines a corresponding optical path 323a-c.

In the arrangement of Figures 9A-C and/or Figures 10A-C, the coupling element 320 is optionally configured to divide optical radiation according to wavelength. In other words, in addition to performing the function of re-directing light form the external waveguide 400 towards the photonic element 310, the coupling element 320 may also act as a splitter. In this way, the coupling element 320 may divide the incoming optical radiation into in designed ratios. Alternatively, or additionally, the coupling element 320 may comprise an array of waveguide gratings configured to separate a broadband incident optical radiation into separate wavelengths. The divided optical radiation may be set on different paths, for example towards different optical transmission element 341a-c. This may reduce a number of external waveguides 400a-c in the external waveguide array 400. The wavelengths of interest may reside in the visible wavelength range, for example, one or more wavelengths between 350nm-1000nm, preferably between 400nm-950nm and more preferably between 450nm-850nm.

In the arrangements of Figures 9 and 10, the array of external waveguides 400a-c is shown as perpendicular to the coupling element 320. However, in other arrangements, the external waveguide array 400 may couple to the coupling element 320 at a non-perpendicular angle. For example, as shown in Figures 11 and 12, as viewed in plan view (viewing the X-Y plane), the external waveguides 400a-c are at a non-perpendicular angle to the coupling element 320.

In the arrangement of Figure 11, the one facet 321 of the coupling element 320 coupled to the external waveguide array 400 is configured to enable the non-perpendicular coupling of the external waveguide array 400 to the coupling element 320. For example, the photonic element 310 may be a planar element extending in two directions (X and Y direction of Figure 11) in a plane (X-Y plane of Figure 11. The optical axes of the external waveguides 400a-c of Figure 11 are non-perpendicular to the two directions in which the photonic element 310 extends. This is in contrast to the arrangements of Figures 9 and 10, where the optical axes of the external waveguides 400a-c are parallel to one of the two directions (the X direction) and perpendicular to the other direction (the Y direction) in which the photonic element 310 extends. In particular, in Figures 9 and 10, the optical axes of the external waveguides 400a-c are parallel to a direction (X direction) in which the integrated optical circuit 313 of the photonic element 310 extends, whereas in Figure 11 the optical axes of the external waveguides 400a-c are non-parallel to the direction (X direction) in which the integrated optical circuit 313 of the photonic element 310 extends.

In the arrangement of Figure 11, the said facet 321 could, for example, be diced or etched to enable the coupling of the waveguide array 400a-c to the coupling element 320 at a given angle, for example, at a non-perpendicular angle as shown in Fig. 11. In other words, although the external waveguide array 400 is set at a non-perpendicular angle to the photonic element 310, the one facet 321 of the coupling element 320 is set at an angle such that each external waveguide 400a-c couples to the one facet 321 at a perpendicular angle. In other words, in the arrangement of Figure 11, the plane of the facet 321 is perpendicular to the optical axis of the external waveguides 400a-c, and thus the external waveguide 400a-c may be directly coupled to the facet 321 of the coupling element 320.

In another arrangement, to account for the external waveguide array 400 being arranged at a non-perpendicular angle to the coupling element 320, one or more lens elements 350a-c may be provided between the external waveguides 400a-c and the coupling element 320. For example, in the arrangement of Figure 12, a plurality of lens elements 350a-c are provided between the external waveguides 400a-c and the coupling element 320. The lens elements 350a-c are configured to direct optical radiation from the external waveguides 400a-c to the coupling element 320. In this way, each lens element 350a-c may accommodate for the non-perpendicular angle between the optical axis of the corresponding external waveguide 400a-c and the plane of the facet 321 configured to optically couple to the external waveguide 400a-c.

In the arrangement of Figure 12, the external waveguides 400a-c each comprise a terminal end 402a-c configured such that optical radiation exits the terminal end 402a-c before entering the coupling element 320. The terminal end 402a-c of the external waveguide 400a-c is at a non-perpendicular angle to the optical axis of the external waveguide 400a-c. In other words, in the arrangement of Figure 13, the plane of the facet 321 is non-perpendicular to the optical axis of the external waveguides 400a-c, and thus array of lens elements 350a-c may be used to optically couple the external waveguide 400a-c to the facet 321 of the coupling element 320.

Figures 11 and 12 are depicted as having an arrangement similar to that of Figures 10A-C, in which a plurality of external waveguides 400a-c are received by a coupling element 320 having a plurality of optical paths 323a-c. The same non-perpendicular arrangement of the external waveguides 400a-c in Figures 11 and 12 may also be provided in an arrangement similar to that of Figures 9A-C, in which the plurality of external waveguides 400a-c are received by coupling element 320 comprising a plurality of optical elements each defining an optical path 323a-c.

In the arrangement of Figure 13, the components having the same reference numbers used in Figures 9-12 are as described above unless otherwise stated in the following. Figure 13 depicts an arrangement wherein the coupling element 320 extends between the external waveguide 400 and the photonic element 310. With this arrangement, the use of an additional optical element, such as an optical via, to provide an optical path between the coupling element 320 and the photonic element 310 is avoided.

The arrangement may be used in a configuration including a substrate 330 on the further major surface 312 of the photonic element 310, as shown in Figure 13. In the arrangement of Figure 13, the coupling element 320 extends along a side surface 335 of the substrate 330. In the arrangement of Figure 13, the side surface 335 of the substrate 330 is perpendicular to the further major surface 312. In alternative arrangement, the angle between the side surface 335 and the further major surface 312 may be offset from the perpendicular. In another arrangement (not shown in the figures), there may not be a substrate on the further major surface 312 of the photonic element 310.

In the arrangement of Figure 13, the coupling element 320 is directly coupled to a side surface 315 of the photonic element 310. In particular, one facet 321 of the coupling element 320 is optically coupled directly to the external waveguide 400, similarly to the arrangements of Figures 9-12. However, in the arrangement of Figure 13, the other facet 322 of the coupling element 320 is optically coupled directly to the photonic element 310.

In the arrangement of Figure 13, the side surface 315 of the photonic element 310 is perpendicular to the major surface 311 of the photonic element 310 facing the sample 208. In an alternative arrangement, the angle between the side surface 315 and the major surface 311 may be offset from the perpendicular.

The coupling element 320 may be attached to the photonic element 310 by an adhesive 360. The optical path between the coupling element 320 and the photonic element 310 is shown by the arrows in Figure 13. As shown in Figure 13, the adhesive 360 is desirably offset from the optical path between the coupling element 320 and the photonic element 310. In this way, the optical radiation may pass from the coupling element 320 to the photonic element 310 without being influenced by the adhesive 360.

The coupling element 320 of Figure 13 may be similar to that described above with respect to Figures 10A-C. In particular, the coupling element of Figure 13 may comprise a grating coupler configured to couple optical radiation into the photonic element 310. The grating coupler may be configured to receive optical radiation traveling in one direction (e.g., a vertical downward, or negative Z direction of Figure 13) and re-direct the optical radiation to travel in another direction (e.g., a horizontal left direction, or negative X direction of Figure 13). The one direction and the other direction are at an angle to each other. The grating coupler may receive optical radiation travelling in the one direction, re-direct the optical radiation and emit the optical radiation along an optical path in the other direction. The one direction may be the direction at which the optical radiation is incident on the grating coupler, and the other direction is the direction in which the optical radiation is emitted from the grating coupler. For example, the one direction may be normal to the plane of the further grating coupler, and the other direction may be in the plane of the further grating coupler. In other words, the grating coupler is configured to turn the optical path of the optical radiation by an angle between the one direction and the other direction. The angle between the one direction and the other direction may be the same as the angle between the side surface 315 and the major surface 311, for example a 90° angle in Figure 13. The angle may be between 40° and 140°, preferably between 70° and 110°, more preferably between 80° and 100°, yet more preferably the angle may be between 85° and 95°.

The photonic element 310 may comprise an edge coupler configured to receive optical radiation emitted from the coupling element 320 and to direct the optical radiation through the photonic element 310.

One or both of the photonic element 310 and the coupling element 320 may comprise an integrated optical circuit 313, such as a photonic integrated circuit. The integrated optical circuit 313 being configured to manipulate an optical path of optical radiation through the respective component and towards another component.

In an alternative arrangement (not shown in the figures), the coupling element 320 may be directly coupled to the further major surface 312 of the photonic element 310. In particular, one facet 321 of the coupling element 320 is optically coupled directly to the external waveguide 400, similarly to the arrangements of Figures 9-12. However, the other facet 322 of the coupling element 320 is optically coupled directly to the further major surface 312 of the photonic element 310. In this arrangement, the photonic element 310 may comprises a grating coupler configured to receive optical radiation from the coupling element 320. The grating coupler may be configured to receive optical radiation traveling in a first direction (e.g., a vertical downward direction) and re-direct the optical radiation to travel in a second direction (e.g., a horizontal direction), at an angle to the second direction. The angle between the first direction and the second direction may be the same as the angle between the side surface 315 and the major surface 311. The angle may be between 70° and 110°, preferably between 80° and 100°, more preferably the angle may be between 85° and 95°, for example 90°.

In some embodiments, the substrate 330 may form part of a non-optical substrate of the charged particle-optical device 230. The non-optical substrate may comprise a detector, e.g., an electrode plate or a detector array. The electrode plate may be configured to operate on the one or more charged particle beams projected towards a sample 208 or emitted from the sample 208. The detector may be configured to detect charged particles emitted from the sample 208.

For example, the charged particle-optical device 230 may comprise a plurality of components arranged in sequence from an upbeam position, towards the source 201, to a downbeam position, towards the sample 208. The plurality of components may be referred to as a stack 502. The components of the stack 502 may comprise a plurality of plate-like structures. The plate-like structures may have one or more apertures for passage of one or more charged particle beams towards the sample 208. For example, the plate-like structures may have an array of apertures 266 as shown, for example, in plate 261 of Fig. 2.

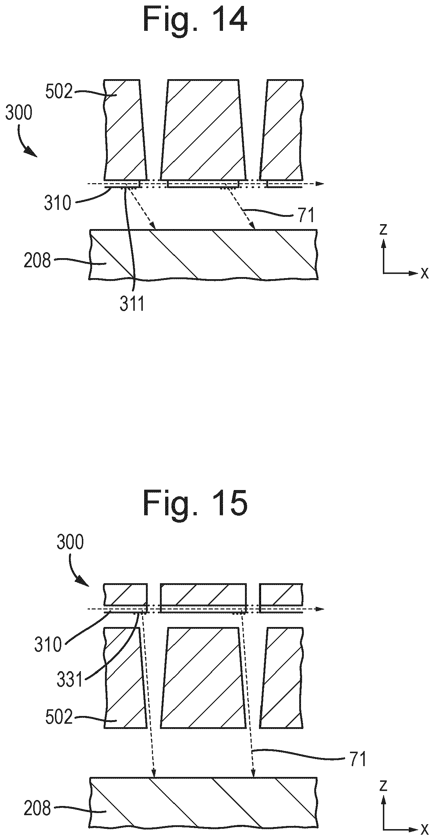

In one arrangement, the optical component 300, as described above in reference to any of Figures 9-13, may be configured to couple the optical radiation out at the bottom of a stack 502, as shown in Figure 14, and as described with respect to Figure 13 of WO 2024/088718 A1. A major surface 311 of the photonic element 310 may be a most downbeam surface of the charged particle-optical device 230. In other words, the major surface 311 may be configured to face the sample 208. The optical radiation 71 may therefore have a clear route between the photonic element 310 and the sample 208, without any other component being disposed between the photonic element 310 and the sample 208. The optical component may also comprise one or more apertures for the passage of the one or more charged particle beams.

In another arrangement, the optical component 300 may be configured to couple the optical radiation out such that the optical radiation 71 is directed on an optical path through apertures for the charged particle beams in a bottom-most element of the stack 502, as shown in Figure 15, and as described with respect to Figure 14 of WO 2024/088718 A1. In other words, the charged particle-optical device 230 may comprise one or more components disposed downbeam of the optical component 300. The optical component 300 is configured to direct light on an optical path to the sample 208 through apertures in the one or more components. In this way, the optical radiation may reach the sample 208 despite the optical component 300 not being the most downbeam component of the charged particle-optical device 230. The optical component may also comprise one or more apertures for the passage of the one or more charged particle beams.

In an embodiment the electron-optical apparatus 140 comprises a secondary electron-optical device comprising the detector array 240. In such an embodiment a beam separator typically is arranged to deflect the path of the signal electrons towards the secondary electron-optical device. The secondary electron-optical device subsequently directs the signal electrons towards the detector array 240 and focuses the signal electrons (e.g. secondary electrons) onto the detector array 240.

Features in electron-optical plates may be manufactured using techniques from microelectromechanical systems (MEMS) (i.e. using MEMS manufacturing techniques). MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other sample) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography. The optical component as described in the different embodiments above may also be used in sensing or detecting applications - in these applications, the photonic element may be configured to receive optical radiation (for example, from a sample) and direct it to an external waveguide via the above-described coupling element.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

Embodiments include the following numbered clauses:
1. An optical component for a charged particle-optical device configured to project one or more charged particle beams towards a sample, wherein the optical component comprises:
   a photonic element configured to project optical radiation towards the sample; and
   a coupling element configured to optically couple an external waveguide to the photonic element, the coupling element comprising two facets that are mutually angled and an optical path between the two facets.
2. The optical component according to any preceding clause, wherein the photonic element is a planar photonic element.
3. The optical component according to either of clauses 1 or 2, wherein the photonic element comprises an integrated optical circuit on a major surface of the photonic element.
4. The optical component according to clause 3, wherein the coupling element is configured to optically couple the external waveguide to the integrated optical circuit of the photonic element.
5. The optical component according to any preceding clause, further comprising a substrate having a through-hole extending between the coupling element and the photonic element, wherein the optical path extends through the through-hole.
6. The optical component according to clause 5, wherein the substrate is disposed on a further major surface of the photonic element, the further major surface being opposite to the major surface of the photonic element.
7. The optical component according to clause 6, wherein the substrate is a non-optical substrate.
8. The optical component according to clause 7, wherein the non-optical substrate is configured to operate on the one or more charged particle beams projected towards a sample or emitted from the sample and optionally wherein the non-optical substrate comprises an electrode plate or a detector.
9. The optical component according to any one of clauses 6 to 8, further comprising an optical element in the optical path between the coupling element and the photonic element, wherein the optical element is configured to direct optical radiation through the through-hole towards the photonic element.
10. The optical component according to clause 9, wherein the optical element comprises an optical transmission element extending through the through-hole of the substrate and having an end optically coupled to the photonic element, wherein one facet of the coupling element is optically coupled to the other end of the optical transmission element.
11. The optical component according to clause 10, wherein the other facet of the coupling element is optically coupled to the external waveguide.
12. The optical component according to either of clauses 10 and 11, wherein the optical transmission element is an optical via or an optical fiber.
13. The optical component according to clause 9, wherein the optical element comprises an optical lens configured to direct optical radiation from the coupling element through the through-hole towards the photonic element.
14. The optical component according to any of clauses 5 to 13, wherein the through-hole is perpendicular to a major surface of the photonic element.
15. The optical component according to any preceding clause, further comprising at least one grating coupler configured to couple optical radiation into or emit optical radiation out of the photonic element.
16. The optical component according to clause 15, wherein the photonic element comprises the at least one grating coupler.
17. The optical component according to any preceding clause, further comprising at least one edge coupler configured to direct optical radiation from the external waveguide to the coupling element.
18. The optical component according to clause 17, wherein the coupling element comprises the at last one edge coupler.
19. The optical component according to any preceding clause, further comprising a further edge coupler configured to couple optical radiation out of the coupling element towards the photonic element.
20. The optical component according to clause 19, wherein the coupling element comprises the further edge coupler.
21. The optical component according to any preceding clause, comprising an array of coupling elements, wherein each coupling element in the array of coupling elements is configured to provide a respective optical path between the two facets for coupling optical radiation from a corresponding external waveguide, in an array of external waveguides, to the photonic element.
22. The optical component of clause 21, wherein one or more coupling elements in the array of coupling elements comprise one or more photonic integrated circuits.
23. The optical component according to any of clauses 1 to 18, comprising at least one further grating coupler configured to couple optical radiation out of the coupling element towards the photonic element.
24. The optical component according to clause 23, wherein the coupling element comprises the at least one further grating coupler.
25. The optical component according to any of clauses 1 to 18, 23 and 24, wherein the coupling element comprises a photonic integrated circuit, wherein the photonic integrated circuit is configured to provide a plurality of optical paths between the two facets, wherein each optical path is configured for optical radiation from a corresponding external waveguide in an array of external waveguides.
26. The optical component according to any preceding clause, wherein the optical axis of the external waveguide extends in a non-perpendicular direction with respect to the photonic element.
27. The optical component according to clause 26, wherein the one facet of the coupling element coupled to the external waveguide is perpendicular to the external waveguide.
28. The optical component according to clause 27, wherein the one facet of the coupling element coupled to the external waveguide has a diced or etched surface.
29. The optical component according to clause 26, further comprising one or more lens elements between the waveguide and the coupling element, wherein the one or more lens elements are is configured to direct optical radiation from the waveguide to the coupling element.
30. The optical component according to clause 29, wherein the external waveguide comprises a terminal end configured such that optical radiation exits the terminal end before entering the coupling element, wherein the terminal end of the external waveguide is at a non-perpendicular angle to a longitudinal direction of the external waveguide.
31. The optical component according to clause 30, further comprising the external waveguide.
32. The optical component according to any preceding clause, wherein the coupling element is configured to divide optical radiation according to wavelength.
33. The optical component of any one of clauses 1 to 4, wherein the coupling element extends between the external waveguide and the photonic element, and wherein the coupling element is configured to directly couple to a side surface of the photonic element, wherein the side surface of the photonic element is perpendicular to a major surface of the photonic element.
34. The optical component of clause 33, wherein the coupling element is attached to the photonic element by an adhesive.
35. The optical component of either of clauses 33 and 34, further comprising a grating coupler configured to couple optical radiation into the integrated optical element of the photonic element.
36. The optical component according to clause 35, wherein the photonic element comprises the grating coupler.
37. The optical component of any one of clauses 33 to 36, further comprising a substrate disposed on a further major surface of the photonic element.
38. The optical component of clause 37, wherein the coupling element extends along a side surface of the substrate, wherein the side surface is perpendicular to the major surface.
39. The optical component according to any preceding clause, wherein the optical element comprises an optical emitter configured to emit optical radiation towards the sample.
40. The optical component of clause 39, wherein the optical emitter comprises a grating coupler configured to receive optical radiation and emit the received optical radiation towards the sample.
41. A charged particle-optical device configured to project one or more charged particle beams towards a sample, the charged particle-optical device comprising an optical component according to any of the preceding clauses and optionally wherein the optical component further comprises one or more apertures for passage of the one or more charged particle beams.
42. The charged particle-optical device of clause 41, wherein a major surface of the photonic element is a most downbeam surface of the charged particle-optical device, and wherein the major surface is configured to face the sample.
43. The charged particle-optical device of clause 42, further comprising a charged particle-optical component for projecting one or more charged particle beams towards a sample, the charged particle-optical component comprising the optical component and optionally wherein the charged particle-optical component is a detector.
44. The charged particle-optical device of clause 41, further comprising one or more components disposed downbeam of the optical component, wherein the optical component is configured to direct optical radiation on an optical path towards the sample through apertures in the one or more components.
45. An assessment apparatus for inspecting the sample, comprising the charged particle-optical device of any one of clauses 41 to 44.

### List of reference numerals:

71 optical radiation
100 assessment apparatus
110 vacuum chamber (main chamber)
120 load lock chamber
124 gun aperture
125 beam limit aperture
130 EFEM
130a first loading port
130b second loading port
132a pole piece
132b control electrode
132c deflector
132d exciting coil
135 column aperture
140 electron-optical apparatus (electron beam apparatus, electron apparatus)
148 first multipole lens
150 controller
158 second multipole lens
201 source
202 source beam
204 electron-optical axis
207 sample holder
208 sample
209 actuatable stage
211, 212, 213 primary beams (sub-beams, beamlets)
220 source converter (micro-optical array)
223 pre-bending deflector array
224 aberration reduction array
230 electron-optical device (electron-optical column)
231 condenser lens array
240 detector array
241 objective lens array
242 beam shaper array
243 objective lens
250 control lens array
252 beam limiting aperture array
260 scan deflector array
261 plate
264 detector substrate
265 detector elements
266 beam apertures
267 logic layer
268 wiring layer
269 through-substrate vias
270 macro collimator
271 collimator array
272 Coulomb aperture array
273 intermediate focus plane
274 macro condenser lens
275 macro scan deflector
281-283 probe spots
291 photon converter array
292 fluorescent strip
293 openings
295 deflector array
296 magnetic deflector
297 electrostatic deflector
298 optical fiber
299 electron-optical device array
300 optical component
310 photonic element
311 major surface
312 further major surface
313 integrated optical circuit
314a-c grater coupling
315 side surface
320 coupling element
320a-c coupling elements
321, 322 facets
323a-c optical paths
330 substrate
331 surface
340a-c through-holes
341a-c optical transmission elements
350a-c lens elements
360 adhesive
400 external waveguide array
400a-c external waveguides
410 V-groove array assembly

## Claims

1. An optical component for a charged particle-optical device configured to project one or more charged particle beams towards a sample, wherein the optical component comprises:
a photonic element configured to project optical radiation towards the sample; and
a coupling element configured to optically couple an external waveguide to the photonic element, the coupling element comprising two facets that are mutually angled and an optical path between the two facets.

2. The optical component according to claims 1, wherein the photonic element comprises an integrated optical circuit on a major surface of the photonic element.

3. The optical component according to claim 2, wherein the coupling element is configured to optically couple the external waveguide to the integrated optical circuit of the photonic element.

4. The optical component according to any preceding claim, further comprising a substrate having a through-hole extending between the coupling element and the photonic element, wherein the optical path extends through the through-hole.

5. The optical component according to claim 4, wherein the substrate is disposed on a further major surface of the photonic element, the further major surface being opposite to the major surface of the photonic element.

6. The optical component according to claim 5, wherein the substrate is a non-optical substrate.

7. The optical component according to claim 6, wherein the non-optical substrate is configured to operate on the one or more charged particle beams projected towards a sample or emitted from the sample.

8. The optical component according to any one of claims 5 to 7, further comprising an optical element in the optical path between the coupling element and the photonic element, wherein the optical element is configured to direct optical radiation through the through-hole towards the photonic element.

9. The optical component according to claim 8, wherein the optical element comprises an optical transmission element extending through the through-hole of the substrate and having an end optically coupled to the photonic element, wherein one facet of the coupling element is optically coupled to the other end of the optical transmission element.

10. The optical component according to claim 9, wherein the other facet of the coupling element is optically coupled to the external waveguide.

11. A charged particle-optical device configured to project one or more charged particle beams towards a sample, the charged particle-optical device comprising an optical component according to any of the preceding claims.

12. A charged particle-optical device according to claim 11, wherein the optical component further comprises one or more apertures for passage of the one or more charged particle beams.

13. The charged particle-optical device of claim 11 or 12, wherein a major surface of the photonic element is a most downbeam surface of the charged particle-optical device, and wherein the major surface is configured to face the sample.

14. The charged particle-optical device of claim 11 or 12, further comprising one or more components disposed downbeam of the optical component, wherein the optical component is configured to direct optical radiation on an optical path towards the sample through apertures in the one or more components.

15. An assessment apparatus for inspecting the sample, comprising the charged particle-optical device of any one of claims 11 to 14.
